# EUROPEAN PATENT SPECIFICATION

(11) **EP 3 146 088 B1**
(45) Date of publication and mention of the grant of the patent: **25.07.2018**
(21) Application number: 15725409.5
(22) Date of filing: 21.05.2015
(51) Int. Cl.: C23C 16/30, C23C 16/40

(54) **DEPOSITION OF ZINC OXYSULPHIDE BY CVD**
ABSCHEIDUNG VON ZINKOXYSULFID MITTELS CVD
DÉPÔT CHIMIQUE EN PHASE VAPEUR D'OXYSULFURE DE ZINC

(30) Priority: 22.05.2014 GB 201409135
(43) Date of publication of application: 29.03.2017
(73) Proprietor: Pilkington Group Limited, Nr. Ormskirk, Lancashire L40 5UF (GB)
(72) Inventor: PALMER, Liam Sonie, Southport Merseyside PR9 0RT (GB); HARRIS, Peter Michael, Chester Cheshire CH2 4DT (GB); STRICKLER, David Alan, Toledo, Ohio43606 (US); NICHOL, Gary Robert, Warrington Cheshire WA3 4NQ (GB); COLLEY, Anna Louise, Prescot Merseyside L35 4LT (GB)
(74) Representative: Teasdale, Nicola Joanne
(86) International application number: PCT/GB2015/051490
(87) International publication number: WO 2015/177552

(56) References cited:
- IN-HWAN CHOI ET AL: "Improvement of the energy conversion efficiency of Cu(In,Ga)Se2 solar cells using an additional Zn(S,O) buffer", THIN SOLID FILMS, vol. 525, 1 December 2012 (2012-12-01), pages 132-136, XP055132049, ISSN: 0040-6090, DOI: 10.1016/j.tsf.2012.07.137
- Matthew J Almond ET AL: "Growth of Il-VI Compounds by Metal-Organic Chemical Vapour Deposit ion Propylene Sulfide: A Novel Sulfur-containing Precursor for MOCVD Growth of ZnS", J. MATER. CHEM, 1 January 1995 (1995-01-01), pages 853-854, XP055207497, Retrieved from the Internet: URL:http://pubs.rsc.org/en/content/article pdf/1995/jm/jm9950500853 [retrieved on 2015-08-12]

## Description

The invention is concerned with the production of coatings having the general formula ZnO₍₁₋ₓ₎Sₓ, 0 ≤ x ≤ 1, referred to herein as zinc oxysulphides. It should be noted that the scope of the invention includes the cases where x=0 and x=1, hence the term 'zinc oxysulphide' as used herein includes zinc oxide and zinc sulphide.

Zinc oxysulphide is a material of interest in a number of applications. Use of the material as a cadmium free buffer layers in cadmium indium diselenide solar cells has been studied by Yousfi (Thin Solid Films, 361, 2000, 183-186). In this work, the range of compounds referred to herein as zinc oxysulphide was studied. ZnO_{0.85}S_{0.15} gave the best overall results, as while pure ZnS had the highest V_{oc} its fill factor and current densities were low. The work also showed that the crytallinity of the material and the bandgap reached a minimum when x= 0.4 -0.6. This was assigned to the large lattice mismatch between the ZnO and ZnS. Increasing the amount of sulphur also showed an increase in the resistivity.

US8377343 describes a sputtered zinc oxysulphide coating to show variable dielectric responses. The patent teaches that it is able to offer protection from UV radiation while transmitting electromagnetic radiation of larger wavelengths. The coating can be adjusted in the uv range of the relatively sharp absorption constant.

Sanders (Chem Mater. 1992, 4, 1005-1011) describes a zinc oxysulphide film, deposited by ALD, separating into a two phases system when x reaches a value of 0.56. This paper describes how the transparency of the film makes ZnOS desirable for use in thin film phosphors.

ZnS is described as having potential in the area of infrared optics. ZnS is described as having an excellent optical transmission with a broad transmission band from 0.4 µm in the visible to about 14 µm in the infrared, a high value of refractive index, good stability of refractive index and a low scatter. Large, 10 mm thick, polycrystalline ZnS has been made using CVD F. (Zhenyi, Journal of Crystal Growth 237-239 , 2002, 1707-1710).

Deposition of ZnS by CVD using hydrogen sulphide as the sulphur source is known (Journal of Crystal Growth 237-239 2002 1707-1710).
Other techniques for deposition of zinc oxysulphide are documented including: pulsed laser deposition (Journal of Electronic Materials, Vol. 39, No. 5, 2010); rf sputtering (Vac Sci Sci Tech. A 9, 4, 1991 2447); chemical bath deposition (Materials Chemistry and Physics 96 2006 84-89) and ALD (Chem. Mater. 1992,4,1005-1011).
US5284519 describes the use of propylene sulphide to produce iron sulphide films.

In-Hwan Choi et al. in Thin Solid Films 525 (2012) 132-136 disclose a Zn(S,O) buffer layer formed by a sequential deposition process using diethyl zinc, t-butyl thiol and water vapour as precursors. M.J.Almond et al. in J.Mater.Chem. 5(6) (1995) 853-854 disclose the use of dimethyl zinc together with propylene sulphide to deposit ZnS. The deposition of coatings on a glass or other substrate, by Chemical Vapour Deposition (CVD) techniques, is well known. This can conveniently be done 'on-line' i.e. where the coating is continuously deposited directly on the glass ribbon that is produced during the float glass manufacturing process. Chemical precursors of the coating material are directed to the vicinity of the glass ribbon where they react to form the coating on the glass. This reaction may is typically assisted by residual heat in glass from the float process.
WO9806675 is an example publication showing on-line coating of glass substrates by CVD.
For some coating chemistries, it is necessary to keep the precursors separate until they reach the vicinity of the substrate. This requires relatively complex delivery systems wherein each precursor is provided with a dedicated delivery line (pipe) and a coating beam having multiple slots. WO2013/019285 describes apparatus for Chemical Vapour Deposition of coatings on a glass substrate during the float glass production process, in which the reactants are delivered to the coating (reaction) site separately.
Where possible, it can be advantageous to pre-mix the precursors as these can then be delivered to the substrate by a single delivery line. This allows for much simpler coating equipment. However, in order to use this approach, precursors must be identified which do not pre-react or otherwise decompose before they reach the substrate.

Dialkyl zinc, particularly dimethly zinc (DMZ) and diethyl zinc (DEZ) are possible candidates as precursors for the deposition of compounds containing zinc by CVD but previous experience suggests that these compounds are too reactive for pre-mixing with other precursors. Previous attempts to use dialkyl zinc in this way has led to pre-reaction of the precursors, i.e. reaction before they reach the deposition surface, and this in turn has led to blockage of the CVD apparatus and exhaust systems with reaction products. This is a particular problem where the substrate temperature is >400C and causes problems when trying to operate such a process in a float bath environment with a temperature in the range 580-650C.

A zinc based coating chemistry which allows precursors to be pre-mixed, thereby obviating the need for complicated apparatus for keeping the precursors separate until they reach the deposition surface, without causing such blocking of the deposition apparatus, represents a substantial advance in the art.

It is an object of this invention to provide convenient methods for deposition of zinc oxysulphide coatings on a substrate, particularly a continuous glass ribbon as produced during the float glass manufacturing process.

According to the invention, a method of forming a coating comprising ZnO₍₁₋ₓ₎Sₓ, where 0 ≤ x ≤ 1, on a substrate by Atmospheric Pressure Chemical Vapour Deposition, comprising the steps of:
forming a mixture of precursors comprising a zinc source, a sulphur source and an oxygen source and directing said mixture to a surface of the substrate, wherein:
the zinc source comprises at least one of dimethyl zinc and diethyl zinc;
the sulphur source comprises at least one of an episulphide and a sulphoxide and the oxygen source comprises at least one of nitrous oxide; a carboxylic ester and dimethyl sulphoxide.

Preferably, the coating is produced in a float glass bath at a substrate temperature in the range 550 - 750C, more preferably 580 - 650C.

In one embodiment, the sulphur source comprises ethylene sulphide.

In another embodiment, the sulphur source comprises propylene sulphide.

In another embodiment, the sulphur source comprises methyl phenyl sulphoxide.

In another embodiment, the sulphur source comprises dimethyl sulphoxide.

In preferred embodiments, the oxygen source comprises ethyl acetate or tert-butyl acetate. The oxygen source may also comprise nitrous oxide.

Following investigation of a number of possible precursors for the deposition of zinc oxysulphide by chemical vapour deposition, the inventors have discovered methods by which oxygen/sulphur content in the resultant coatings may be controlled and pre-reaction of alkyl-zinc precursors may be reduced.

The invention will now be described with reference to:
figure 1, which shows schematically, a static coater used for laboratory scale chemical vapour deposition experiments and
figure 2, which shows schematically, a dynamic coater used for deposition of coatings on a moving glass substrate by Atmospheric Pressure Chemical Vapour Deposition.

### Experimental

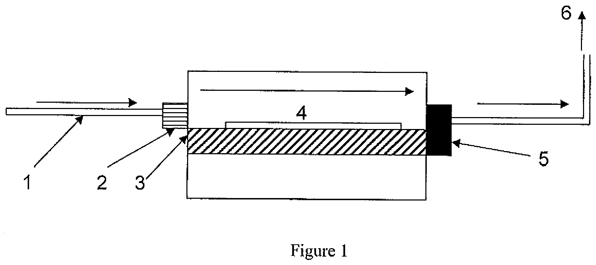

Referring to figure 1, initial trials for the deposition of ZnOS were performed on a laboratory scale 'static coater' wherein the premixed precursors move towards the coater through a heated line 1 before they reach baffle section 2 which equalises the precursor flow before it enters the sealed coating section. The glass substrate 4 sits on a heated carbon block 3 which is heated to the desired temperature using either heating elements (not shown) inserted inside the carbon block or by an induction coil (not shown) around the sealed coating section. Any unreacted precursor or by products are then directed towards fish tail exhaust 5 and continue towards the incinerator 6. The arrows show the direction in which the gaseous mixture moves.

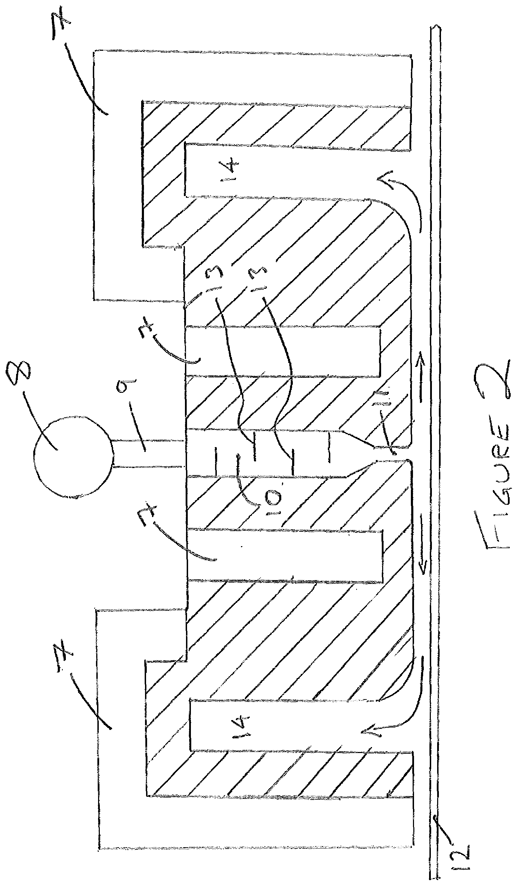

Referring to figure 2, a coating beam for supplying precursors according to the invention to a float glass substrate, during the float glass manufacturing process, has a generally linear configuration and is shown in cross section. The beam comprises a box section framework having cavities 7 through which a fluid such as oil may be circulated to maintain the temperature of the apparatus by heat exchange.

Precursor gas mixture is supplied via conduit 8 (which may also be fluid cooled) extending along the coating beam, and through drop lines 9 spaced along conduit 8. The precursor gas mixture, so delivered by drop lines 9 enters a delivery chamber 10 and then passes through passage 11 to the surface region of glass substrate 12 where they flow in the direction of the arrows.

Baffles 13 may be included in the delivery chamber to provide for a more uniform flow and distribution of precursor materials across the substrate 12.

Spent precursor materials are removed through exhaust chambers 14.

The coating beam illustrated in figure 2 is referred to as a bi-directional beam because the precursor mixture flows in two directions across the substrate 12 on exiting passage 11. (The two directions correspond to 'upstream' and 'downstream' for a dynamic coater below which the substrate is passed).

A laboratory scale dynamic coater based on the apparatus illustrated in figure 2 was also used for some experiments. It comprised an essentially similar (but simplified) design where precursors were delivered directly to chamber 10, which did not include baffles 13.

Initial experiments were concerned with generating a zinc oxide (ZnO) baseline coating.

DEZ was used as the zinc precursor and ethylacetate initially served as the oxygen source (DEZ being pyrophoric and reacting violently with water or oxygen).

Delivery lines were warmed to above 100°C to prevent condensation of the ethylacetate and ZnO films were obtained. However, these were very thin.

Substitution of ethylacetate with tertiary butyl acetate (tBuOAc) showed the latter to be a more efficient oxidant for zinc, speeding the reaction and producing thicker films (about four fold). These results were verified on both the static coater and the laboratory scale dynamic coater. Nevertheless, even with this more effective oxidant, damage to the underlying fluorine doped tin oxide layer has been observed. This is attributed to rapid decomposition of dialkyl zinc to produce intermediates too quickly for complete oxidation by the ester: the result is a stoichiometrically oxygen deficient coating, which in turn reacts with oxygen in the underlying layer.

It was decided to investigate possible chemistries using the dialkyl zincs and separate sulphur and oxygen containing precursors. Such an approach should also offer greatest scope for controlling the zinc: sulphur ratios in the coatings.

A number of further potential CVD precursors to ZnOS were investigated using a static coater as shown in figure 1 and a laboratory scale dynamic coater as shown in figure 2. These are summarised in table 1.

**Table 1. Potential precursors for deposition of ZnOS**

| **Precursor** | **Structure** | **ZnOS/ZnS from DEZ & sulphur precursor** | **ZnOS from DEZ, sulfur & additional oxidant** | **Comments** |
|---|---|---|---|---|
| Di-tert butyl disulphate | 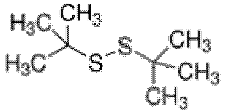 | 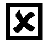 | 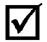 | Very thin coating with only dopant levels of up to 3% sulphur incorporation. Very strong gas like odour released after coating. |
| Propylene sulphide | 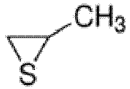 | 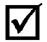 | 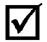 | Good coatings with variable amounts of sulphur incorporation when an additional oxidant was used. Precursor is expensive and very volatile and required chilling. |
| Ethylene sulphide | 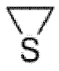 | 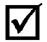 | 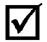 | Similar results to propylene sulphide but ethylene sulphide is a less stable chemical |
| SO₂ | 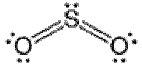 | 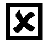 | 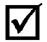 | Pre-reaction seen when only SO₂ was used. Coating achieved when acetone was used as an oxidant. |
| Dimethyl sulfoxide | 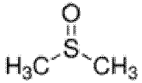 | 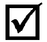 | 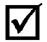 | A cheap sulphur source that is easy to handle. |
| Ethyl thio acetate | 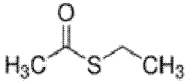 | 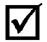 | 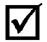 | Zinc sulphide and oxysulfide coatings were made in the laboratory but did not translate onto a production trial |

These precursors were each tried using a static coater as described in figure 1. The precursors were delivered in a nitrogen carrier gas via bubblers with a total flow rate of 12slm (litres min⁻¹). Delivery lines were maintained at a temperature of about 150°C.

The zinc containing precursor was diethyl zinc.
Each of these precursors will be further commented on below.

### Ditertbutyl disulphide.

Use of this precursor as a sulphur source for atmospheric pressure CVD (APCVD) of niobium sulphide has been described (e.g. C. Cammelt et al, J. Inorg. Chem. 2004, 14, 290-291). The use of a scrubber system comprising bubblers containing sodium hypochlorite is described in order to neutralise byproducts.

Modifications were made to the coater system described in figure 1, to include three bubblers filled with an alkali bleach solution. Despite these precautions, a strong odour was noted during the experiments.

A number of experiments were performed with varying ratios of precursors. In each case, the coatings produced were revealed by X-ray Diffraction analysis (XRD) to be zinc oxide with only trace levels of sulphur detected.

### Propylene Sulphide

The high volatility of episulphides meant that this chemical needed to be kept at around 0°C in order to the necessary concentrations in the precursor mixture. This meant that the bubbler was held in an ice bath.
Propylene sulphide proved successful in providing relatively thick, clean coatings on the static coater, using ethyl acetate as an oxidant. Initial analysis showed these coatings contained zinc, oxygen and sulphur.

Further experiments were conducted in which the amount of oxidant and propylene sulphide were varied and these suggested that it is possible to control the ratio of oxygen and sulphur within the coating.

One sample was prepared using no additional oxidant and XPS analysis revealed this to consist of ZnS in a mixture of the sphalerite and wurtzite forms.

Further work was done on the dynamic coater in which the effect of varying the amounts of oxygen and sulphur precursors on the film composition was studied. The results are summarised in table 2.

**Table 2:- variation of coating composition with precursor ratio**

| **% of Precursor in Total Flow** | | | **At% of Element in Coating (XPS)** | | |
|---|---|---|---|---|---|
| **DEZ** | **Ethyl acetate** | **Propylene sulphide** | **Zinc** | **Oxygen** | **Sulphur** |
| 2.7 | 3.7 | 0.08 | 45.4 | 35.1 | 19.2 |
| 2.7 | 3.7 | 0.5 | 53 | 12.8 | 34.2 |
| 2.7 | 3.7 | 1.2 | 48.4 | 5.5 | 46.2 |

Table 2 shows that by increasing the amount of propylene sulphide, it is possible to increase the amount of sulphur incorporated in the coating, up to a level where only a doping level of oxygen is present. Even with the smallest percentage if propylene sulphide in the precursor mixture, where the ethyl acetate component was some 47 times greater, a significant amount of sulphur (over 19%) was still present in the coating.

These results suggest that the sulphur precursor is reacting more successfully with zinc than is the ethyl acetate.

Previous work on the production of zinc oxide suggested that t-butyl acetate is a more effective oxidant than ethyl acetate. The use of this oxygen source in the production of ZnOS was investigated next. X-ray Photoelectron Spectroscopy (XPS) analysis of these coatings (made using t-butyl acetate with propylene sulphide and diethyl zinc) had very little sulphur incorporated. Moreover, this did not vary significantly with varying concentrations of t-butyl acetate. These results are summarised in table 3.

**Table 3**

| **% of precursor in total flow** | | | **At% of Element in Coating (XPS)** | | |
|---|---|---|---|---|---|
| **DEZ** | **t-butyl acetate** | **propylene sulphide** | **Zinc** | **Oxygen** | **sulphur** |
| 2.7 | 2.9 | 0.45 | 53 | 12.8 | 34.2 |
| 2.7 | 2 | 0.45 | 50.9 | 8.1 | 41 |
| 2.7 | 3.6 | 0.4 | 43.7 | 50.5 | 5.8 |
| 2.7 | 1.8 | 0.4 | 40.9 | 53.2 | 6 |
| 2.7 | 5.6 | 0 | N/A | N/A | 0 |

A further experiment, with the DEZ precursor reduced from 2.7% to 1% showed no significant impact on the overall coating thickness. This suggests that at >1% DEZ, the DEZ was being run in excess and that the deposition was being limited by oxygen or sulphur availability.

### Ethylene sulphide

As an alternative to propylene sulphide, ethylene sulphide was also tested. The two compounds have similar properties but the latter is more readily available and proved cheaper to purchase on laboratory scales. The results proved very similar to those for propylene sulphide and the same trends were observed.

However, it was subsequently noted that neither of these chemicals were very suitable for full scale trials: they are both relatively expensive; difficult to handle and volatile.

### Ethyl thioacetate (EtSAc)

This compound was identified as a potential single source precursor for both oxygen and sulphur. Films were produced on the static coater by reacting with DEZ and EtOAc. These were fairly thick, relative to other coatings produced with different sulphur precursors at similar ratios and gas phase concentrations. The reaction rate was improved and analysis of the films showed them to be ZnOS.

When no oxidant was used, ZnOS was still produced but with a lower oxygen content.

Films produced from EtSAc on the laboratory scale dynamic coater were less successful, having a loosely adhered powder on top, indicating that there was still a significant pre-reaction occurring.

### Sulphur Dioxide

Although a toxic gas, sulphur dioxide (SO₂) was of interest as a potential sulphur source because it is readily available and is already used during float glass production.

In order to limit the amount of pre-mixing, and thereby reduce the amount of blockage should the precursors pre-react, the SO₂ delivery line was connected just before the coater baffle section 2 (figure 1). When DEZ and SO₂ only were used, no coatings were observed and some black powder was noted on the glass: this suggested pre-reaction of the precursors. It was also suspected that the SO₂ was reacting with the carbon heating block 3 (figure 1).

When EtOAc was also included in the precursor mix, very thin coatings were obtained which were shown by XPS analysis to contain about 2-3% sulphur.

Use of t-butyl acetate as oxidant provided thicker coatings and XPS analysis showed these to contain zinc and oxygen only.

SO₂ and DEZ did produce a coating when acetone was added as an oxidant. This coating was relatively thick, appeared quite yellow in transmission, and was revealed by XPS analysis to contain about 18% sulphur. XRD analysis characterised the coating as a mixture of zincite ZnO and wurtzite ZnS.

### Dimethylsulphoxide (DMSO)

This compound was identified as a potentially useful sulphur source due to its stability, ease of handling, low toxicity and relatively low cost. Experiments on the static coater showed ZnSO coatings could be produced and suggested that some level of control could be achieved over the relative amounts of sulphur and oxygen incorporated.

The results further reinforced the view that t-butyl acetate is a more effective oxidant that EtOAc, the latter giving rise to a higher sulphur incorporation. Indeed, the composition of coatings obtained using DMSO and DEZ (about 30% sulphur and 20% oxygen) was largely unaffected by the additional use of EtOAc.

In other words, t-butyl acetate may be used as oxidant to produce a coating that is closer to ZnO in character, with just small amounts of sulphur incorporated, whereas true ZnOS films may be obtained using EtOAc as oxidant.

### Large Scale Trials

Following the initial series of experiments in the laboratory, a set of trials were performed in a float glass production environment, using full scale coaters (see figure 2). The objectives of these trials were further to investigate the suitability of ethylthioacetate EtSAc and dimethylsulphoxide (DMSO) as sulphur precursors using three different oxidants: t-butyl acetate, ethyl acetate (EtOAc) and N₂O.

As previously noted, ZnOS is of interest as a potential buffer layer in cadmium indium diselenide and cadmium telluride based photovoltaic devices. The large scale trials involved coatings done on NSG TEC® glass, a coated glass substrate providing a transparent conducting electrode based on a fluorine doped tin oxide.

In addition, it was important to verify that the coating process, using the dialkyl zinc precursor, could be run for a significant amount of time without blocking the coaters exhausts. Dialkyl zincs are known as extremely reactive materials and previous trials using these materials have failed because they decompose before reacting with the oxidants. Suitable [oxygen and sulphur] precursors are therefore sought which can match the fast reaction kinetics of the DEZ or that are able to slow the reaction by forming an intermediate complex or adduct that will help to stabilise the zinc-containing material. The fast reaction kinetics of DEZ means that, prior to the current invention, the perceived wisdom was that pre-mixing of precursors would not work for reactions involving DEZ and multi-slot coaters of the type described in WO2013/019285 were needed.

Dimethyl zinc (DMZ) and diethyl zinc (DEZ) each may serve as such a zinc precursor.
The former has the advantage that it has slightly slower reaction kinetics: the latter has the advantage that, at the time of the invention at least, it is far less expensive.

### Large scale trials using ethylthioacetate (EtSAc) as precursor.

First, a ZnS coating was produced using DEZ (2%) and EtSAc (4%) with no additional oxidant. The coating was hazy in appearance with loose powder atop. After running the experiments for about an hour, significant blocking of the coater exhausts was observed which necessitated stopping and cleaning the exhausts by nitrogen purging.
Reduction of the DEZ concentration from 2% to 1% along with addition of t-butyl acetate (0.5% - 2%), resulted in a cleaner, less powdery coatings but exhaust blocking still occurred after about 20 minutes. This procedure was repeated several times with similar results.
A zinc oxide coating produced using a DEZ:t-butyl acetate ratio of 1:7.5 began to block the exhausts after a few minutes.
The t-butyl acetate was then replaced with N₂O as oxidant with DEZ:N₂O ratios of 1:10, 1:20, 1:30 and 1:40. The appearance of haze increased with N₂O ratio up to 30%: the experiments were run for over 1.5 hours with no evidence of exhaust blocking being seen.
The focus of the trials then changed to the use of DMSO as the sulphur precursor. During the experiments with this compound, the coaters were run for about five hours with no evidence of exhaust blocking. Coatings deposited on NSG TEC® showed only a very small increase in sheet resistance, which suggests minimal damage to the tin oxide.
Without wishing to be bound by theory, it is speculated that sulphoxide compounds such as DMSO and methyl phenyl sulphoxide form an intermediate species with the dialkyl zinc and this slows down decomposition, enabling reaction with the oxidant at the glass surface resulting in deposition of the coating.

The first of these experiments used only DEZ and DMSO in ratios from 1:0.5 to 1:4. This produced coatings that appeared non-hazy and uniform with no apparent effect on absorption. A large increase in reflection was seen, which decreased as the amount of DMSO was increased - suggesting that the coating was becoming thinner.

The largest increase in reflection was seen at the 1:0.75 ratio.

Table 4 shows the results of XPS analysis for the coatings produced from DEZ and DMSO only.

**Table 4: Composition of coatings made with DEZ and DMSO**

| | **Precursor %** | | **XPS Composition (%)** | | | |
|---|---|---|---|---|---|---|
| **Sample** | **DEZ** | **DMSO** | **Zn** | **O** | **S** | **C** |
| 8190-66C | 1 | 1 | 46.4 | 30.9 | 21.3 | 0.0 |
| 8190-79C | 1 | 2 | 39.3 | 35.3 | 15.3 | 6.0 |
| 8190-91C¹ | 1 | 4 | 34.5 | 31.9 | 19.3 | 8.4 |
| 8190-106C | 1 | 0.75 | 45.8 | 31.3 | 21.0 | 1.4 |
| 8190-135C² | 1 | 1 | 48.5 | 29.5 | 22.0 | 0.0 |
| 8190-151C² | 1.5 | 1.5 | 50.4 | 27.3 | 21.9 | 0.0 |

| | | | | | | |
|---|---|---|---|---|---|---|
| 1 thin coating; 2 coating done on SiO₂ | | | | | | |

The percentage concentrations quoted from XPS analysis in table 4 were taken at the point with the highest recorded value of sulphur. An increase in the concentration of the DMSO resulted in a thinner coating and, apparently, a higher carbon content. However, this could be attributed to surface contamination and it is therefore difficult to quantify when analysed on a rough base coating.

A set of experiments were then performed in which ethylthioacetate (EtSAc) was added to the DMSO/DEZ chemistry, in an attempt to increase the amount of oxygen in the coating. The coatings thus produced still appeared to have low absorption but with a lower reflection.

Next, N₂O was tried with the DMSO/DEZ chemistry (DEZ:N₂O = 1:30, DEZ:DMSO = 1:1, 1:2). Again the films appeared non-absorbing but they did not exhibit the great increase in sheet resistance noted in previous work.

Table 5 shows that addition of N₂O to the DMSO/DEZ chemistry had little effect on the coating composition (cf. table 4).

**Table 5: Composition of coatings made with DEZ, DMSO and N₂O**

| | **Precursor %** | | | **XPS Composition (%)** | | | |
|---|---|---|---|---|---|---|---|
| **Sample** | **DEZ** | **DMSO** | **N₂O** | **Zn** | **O** | **S** | **C** |
| 8190-261C | 1 | 1 | 30 | 47.2 | 30.4 | 20.6 | 0.0 |

Previous work using N₂O as an oxidant with DEZ to produce ZnO, gave rise to a high increase in sheet resistance (by up to 12Ω/square). The coatings were porous and this resulted in an anti-reflective effect when deposited on the NSG **TEC™** glass Substrate. The combination of DEZ, DMSO and N₂O gave rise to a significantly lower sheet resistance than this, around 11Ω/square, which is only about 2Ω/square higher than base NSG **TEC™** glass used as a substrate. It is speculated that the increase in resistance is caused by the zinc based coating damaging the underlying tin oxide coating, particularly when the former is oxygen deficient and addition of the DMSO appears to reduce the extent of that damage.

Increasing the ratio of DMSO to N₂O reduced the coating thickness and the coating was less anti-reflective when the DMSO was added. This suggests a densification of the coating.

For the final set of coatings, t-butyl acetate was used in combination with DMSO in an attempt to produce essentially ZnO, with only doping levels of sulphur.

The addition of the tert-butyl acetate did have an impact on the amount of sulfur incorporated within the coating and increasing this oxidant did reduce the percentage concentration of the sulfur within the film (Table 6). As noted previously, laboratory experiements comparing ethylacetate and tert-butyl acetate as oxidants for the zinc oxide formation have shown tert-butyl acetate to be a significantly more efficient oxidant, producing much thicker zinc oxide films. When the sheet resistance of the TEC overcoated samples were compared it was again found that t-butyl acetate plus DEZ gave coatings of about 16Ω/square, whereas the further inclusion of DMSO gave rise to coatings of about 13Ω/square.

| | **Precursor %** | | | **XPS Composition (%)** | | | |
|---|---|---|---|---|---|---|---|
| **Sample** | **DEZ** | **DMSO** | **tBuOAc** | **Zn** | **O** | **S** | **C** |
| 8190-285C | 1 | 0.5 | 1.5 | 44 | 32.8 | 19.9 | 0 |
| 8190-300C | 1 | 1 | 2 | 42.1 | 44.9 | 7.1 | 2.3 |
| 8190-311C | 1 | 1 | 1 | 43.4 | 36.3 | 16.4 | 0.0 |

Finally, after all experiments to produce coatings were complete, the coater was once again run with just t-butyl acetate and DEZ to verify the tendency of this oxidant to cause blocking of the exhausts. With a DEZ:t-butyl acetate ratio of 1:4, the coater ran successfully for 15 minutes with no significant exhaust blocking. When the ratio was increased to that previously used (1:7.5) the coater exhaust blocked immediately. This demonstrated that the addition of DMSO was beneficial for a commercially relevant coating process.

## Claims

1. A method of forming a coating comprising ZnO₍₁₋ₓ₎Sₓ, where 0 ≤ x ≤ 1, on a substrate by Atmospheric Pressure Chemical Vapour Deposition, comprising the steps of:
forming a mixture of precursors comprising a zinc source, a sulphur source and an oxygen source and directing said mixture to a surface of the substrate, wherein:
the zinc source comprises at least one of dimethyl zinc and diethyl zinc;
the sulphur source comprises at least one of an episulphide and a sulphoxide and
the oxygen source comprises at least one of nitrous oxide; a carboxylic ester and dimethyl sulphoxide.

2. A method according to claim 1, where the coating is produced in a float glass bath at a substrate temperature in the range 550 - 750 °C.

3. A method according to claim 2, wherein the substrate temperature is in the range 580 - 650 °C.

4. A method according to claim 1, 2 or 3 where the sulphur source comprises ethylene sulphide.

5. A method according to claim 1, 2 or 3 where the sulphur source comprises propylene sulphide.

6. A method according to claim 1, 2 or 3 where the sulphur source comprises methyl phenyl sulphoxide.

7. A method according to claim 1, 2 or 3 where the sulphur source comprises dimethyl sulphoxide.

8. A method according to claim 6 or 7, where the oxygen source comprises ethyl acetate.

9. A method according to claim 6 or 7, where the oxygen source comprises tert-butyl acetate.

10. A method according to claim 6 or 7, where the oxygen source comprises nitrous oxide.

## Patentansprüche

1. Verfahren zum Bilden einer Beschichtung, die ZnO₍₁₋ₓ₎Sₓ umfasst, worin 0 ≤ x ≤ 1 ist, auf einem Substrat durch chemische Gasphasenabscheidung bei Atmosphärendruck, das die folgenden Schritte umfasst:
Bilden eines Gemischs von Vorläufern, das eine Zinkquelle, eine Schwefelquelle und eine Sauerstoffquelle umfasst, und Lenken des Gemischs auf eine Oberfläche des Substrats; wobei:
die Zinkquelle mindestens eines von Dimethylzink und Diethylzink umfasst;
die Schwefelquelle mindestens eines von einem Episulfid und einem Sulfoxid umfasst und
die Sauerstoffquelle mindestens eines von Distickstoffmonoxid; einem Carbonsäureester und Dimethylsulfoxid umfasst.

2. Verfahren nach Anspruch 1, wobei die Beschichtung in einem Floatglasbad bei einer Substrattemperatur in dem Bereich 550 - 750 °C hergestellt wird.

3. Verfahren nach Anspruch 2, wobei die Substrattemperatur in dem Bereich 580 - 650 °C liegt.

4. Verfahren nach Anspruch 1, 2 oder 3, wobei die Schwefelquelle Ethylensulfid umfasst.

5. Verfahren nach Anspruch 1, 2 oder 3, wobei die Schwefelquelle Propylensulfid umfasst.

6. Verfahren nach Anspruch 1, 2 oder 3, wobei die Schwefelquelle Methylphenylsulfoxid umfasst.

7. Verfahren nach Anspruch 1, 2 oder 3, wobei die Schwefelquelle Dimethylsulfoxid umfasst.

8. Verfahren nach Anspruch 6 oder 7, wobei die Sauerstoffquelle Ethylacetat umfasst.

9. Verfahren nach Anspruch 6 oder 7, wobei die Sauerstoffquelle tert.-Butylacetat umfasst.

10. Verfahren nach Anspruch 6 oder 7, wobei die Sauerstoffquelle Distickstoffmonoxid umfasst.

## Revendications

1. Procédé pour former un revêtement comprenant du ZnO₍₁₋ₓ₎Sₓ où 0 ≤ x ≤ 1, sur un substrat par déposition chimique en phase vapeur sous la pression atmosphérique, comprenant les étapes consistant à :
former un mélange de précurseurs comprenant une source de zinc, une source de soufre et une source d'oxygène, et diriger ledit mélange vers une surface du substrat, dans lequel :
la source de zinc comprend au moins l'un parmi le diméthyl-zinc et le diéthyl-zinc ;
la source de soufre comprend au moins l'un parmi un épisulfure et un sulfoxyde ; et
la source d'oxygène comprend au moins l'un parmi l'oxyde nitreux, un ester carboxylate, et le diméthylsulfoxyde.

2. Procédé selon la revendication 1, dans lequel le revêtement est produit dans un bain de verre flotté à une température de substrat située dans la plage allant de 550 à 750°C.

3. Procédé selon la revendication 2, dans lequel la température de substrat est située dans la plage allant de 580 à 650°C.

4. Procédé selon la revendication 1, 2 ou 3, dans lequel la source de soufre comprend du sulfure d'éthylène.

5. Procédé selon la revendication 1, 2 ou 3, dans lequel la source de soufre comprend du sulfure de propylène.

6. Procédé selon la revendication 1, 2 ou 3, dans lequel la source de soufre comprend du méthylphénylsulfoxyde.

7. Procédé selon la revendication 1, 2 ou 3, dans lequel la source de soufre comprend du diméthylsulfoxyde.

8. Procédé selon la revendication 6 ou 7, dans lequel la source d'oxygène comprend de l'acétate d'éthyle.

9. Procédé selon la revendication 6 ou 7, dans lequel la source d'oxygène comprend de l'acétate de tert-butyle.

10. Procédé selon la revendication 6 ou 7, dans lequel la source d'oxygène comprend de l'oxyde nitreux.
